# EUROPEAN PATENT SPECIFICATION

(11) **EP 4 134 716 B1**
(45) Date of publication and mention of the grant of the patent: **29.10.2025**
(21) Application number: 22183724.8
(22) Date of filing: 08.07.2022
(51) Int. Cl.: H01L 23/00, G02B 6/12, G02B 6/13

(54) **MULTI-LAYERED HYBRID INTEGRATED CIRCUIT ASSEMBLY**
MEHRSCHICHTIGE HYBRIDE INTEGRIERTE SCHALTUNGSANORDNUNG
ENSEMBLE DE CIRCUIT INTÉGRÉ MULTICOUCHE HYBRIDE

(30) Priority: 09.08.2021 US 202117397141
(43) Date of publication of application: 15.02.2023
(73) Proprietor: Intel Corporation, Santa Clara, CA 95054 (US)
(72) Inventor: SHARMA, Abhishek Anil, Portland, 97229 (US); GOMES, Wilfred, Portland, 97229 (US)
(74) Representative: 2SPL Patentanwälte PartG mbB

(56) References cited:
- EP-A1- 2 685 297
- US-A1- 2003 015 720
- US-A1- 2021 141 154
- US-A1- 2021 166 991
- WIKIPEDIA: "Adhesive bonding of semiconductor wafers", 30 June 2021 (2021-06-30), pages 1 - 11, XP093001269, Retrieved from the Internet <URL:https://en.wikipedia.org/wiki/Adhesive_bonding_of_semiconductor_wafers> [retrieved on 20221123]

## Description

### Technical Field

This disclosure relates generally to the field of integrated circuit (IC) manufacturing, and more specifically, to hybrid integrated circuit assemblies that include photonic and electronic components.

### Background

The need for fast and efficient photonics-based technologies is increasing, e.g., as internet data traffic growth rate is overtaking voice traffic, pushing the need for optical communications. In optical communications, information is transmitted by way of an optical carrier whose frequency is typically in the visible or near-infrared region of the electromagnetic spectrum. A carrier with such a high frequency is sometimes referred to as an optical signal, an optical carrier, a light wave signal, or simply light.

Technological advances today enable implementing portions of some photonic components at the IC (or chip) level, which provides advantages for use of optical communications in computer systems. For example, an optical receiver used in an optical communication system may include a photodetector (PD) implemented on a chip. A photonic integrated circuit (photonic IC (PIC)) is a device that integrates photonic functions for information signals imposed on electromagnetic waves, e.g., electromagnetic waves of optical wavelengths. PICs find application in fiber-optic communication, medical, security, sensing, and photonic computing systems. However, integrating photonic and electronic components is not trivial and further improvements are needed.

EP 2685297 A1 relates to a process for manufacturing a photonic circuit with active and passive structures. The process involves creating a first layer stack on a wafer, the first layer stack comprising a high refractive index waveguide layer, patterning the high refractive index waveguide layer to generate passive photonic structures, smoothing the first layer stack using a planarizing oxide layer, annealing the patterned high refractive index waveguide layer, creating a second layer stack on a different wafer, consisting of a detachable mono-crystalline silicon waveguide layer, transferring and bonding the first layer stack with the second layer stack, creating active photonic devices within the mono-crystalline silicon waveguide layer and achieving evanescent coupling between the mono-crystalline silicon waveguide layer and the high refractive index waveguide layer. US 2021141154 A1 relates to wafer-scale fabrication of optical apparatus, and discusses a method that includes bonding a photonic wafer with an electronic wafer to create a wafer assembly, removing a substrate from the wafer assembly to expose either the surface of the photonic wafer or the electronic wafer, establishing electrical connections between the metal layers of the photonic wafer and the metal layers of the electronic wafer, and adding an interposer wafer to the wafer assembly, cutting the wafer assembly into multiple dies, and exposing the optical edge coupler of each die at the interface created by the cutting process.
US 2003015720 A1 relates to a structure and method for creating a printed circuit board using a semiconductor structure and embedded waveguide. It discusses the growth of high-quality monocrystalline layers over silicon substrates. This is achieved by using a compliant substrate consisting of a monocrystalline oxide layer separated from a silicon wafer by an amorphous interface layer of silicon oxide. The interface layer relieves strain and enables the growth of a high-quality monocrystalline oxide buffer layer that is compatible with both the underlying silicon wafer and the overlying monocrystalline material layer.

### Brief Description of the Drawings

Embodiments will be readily understood by the following detailed description in conjunction with the accompanying drawings. To facilitate this description, like reference numerals designate like structural elements. Embodiments are illustrated by way of example, and not by way of limitation, in the figures of the accompanying drawings.
FIG. 1 provides a schematic illustration of an IC assembly with multiple stacked optical layers, according to some embodiments of the present disclosure.
FIG. 2 provides a schematic illustration of an example IC assembly with multiple optical layers, according to some embodiments of the present disclosure.
FIG. 3 provides a schematic illustration of a first hybrid IC assembly with stacked electronic layers and optical layers, according to some embodiments of the present disclosure.
FIG. 4 provides a schematic illustration of a second hybrid IC assembly with multiple stacked hybrid layers, according to some embodiments of the present disclosure.
FIG. 5 is a first illustration of a cross-section of an electronic layer stacked over an optical layer, according to some embodiments of the present disclosure.
FIG. 6 is a second illustration of a cross-section of an electronic layer stacked over an optical layer, according to some embodiments of the present disclosure.
FIG. 7 is an illustration of a cross-section of two stacked hybrid layers connected by an optical via, according to some embodiments of the present disclosure.
FIG. 8 is an illustration of a cross-section of an electronic layer stacked over an optical layer where the optical layer provides communication between two regions of the electronic layer, according to some embodiments of the present disclosure.
FIG. 9A-9E illustrate an example layer transfer process for forming a hybrid IC assembly with multiple stacked layers.
FIGS. 10A and 10B are top views of, respectively, a wafer and dies that may include one or more hybrid IC assemblies having multiple stacked layers in accordance with any of the embodiments disclosed herein.
FIG. 11 is a cross-sectional side view of a IC package that may include multiple stacked optical and/or electronic layers in accordance with any of the embodiments disclosed herein.
FIG. 12 is a cross-sectional side view of an IC device assembly that may include multiple stacked optical and/or electronic layers in accordance with any of the embodiments disclosed herein.
FIG. 13 is a block diagram of an example computing device that may include multiple stacked optical and/or electronic layers in accordance with any of the embodiments disclosed herein.

### Detailed Description

### Overview

The invention is set out in the appended claims.

For purposes of illustrating hybrid IC assemblies having multiple stacked layers as described herein it might be useful to first understand phenomena that may come into play during IC fabrication. The following foundational information may be viewed as a basis from which the present disclosure may be properly explained. Such information is offered for purposes of explanation only and, accordingly, should not be construed in any way to limit the broad scope of the present disclosure and its potential applications.

IC dies are conventionally coupled to a package substrate for mechanical stability and to facilitate connection to other components, such as circuit boards. The performance that can be realized by such conventional IC packages is constrained by the performance of the die, manufacturing, materials, and thermal consideration, among others. Furthermore, communicating large numbers of signals between two or more dies in a multi-die IC package is challenging due to the increasingly small size of such dies, thermal constraints, and power delivery constraints, among others. Optical communication is being explored as a way to increase bandwidth between dies or within dies. However, photonic components with IC dies having electronic components provides an extra level of difficulty in view of all of these considerations and constraints.

One challenge resides in integrated circuits that include photonic components is that, given a usable surface area of a substrate, there are only so many optical components that can be formed in that area, placing a significant limitation on the density of optical structures. In an optical or hybrid integrated circuit, signals are transmitted using waveguides that propagate light. Waveguides are wider than metal lines (e.g., copper wires) for transmitting electrical signals in electronic-based processing, and it is difficult to reduce their size and maintain functionality.

In electronic circuits, metal, semiconductor, and insulating materials may be deposited in multiple layers to produce stacked structures. Optical structures cannot be built in layers in the same way. In order to propagate light, waveguide are formed of monocrystalline, or single-crystal, material. While one layer of monocrystalline material may be deposited on another monocrystalline material, current deposition methods do not enable monocrystalline materials to be repeatedly deposited, layer-by-layer. For example, each subsequent layer may have a less uniform crystal structure, and after multiple layers have been deposited, the higher layers (e.g., the third or fourth layer) may not have sufficient uniformity to form waveguides and other optical structures.

Embodiments of the present disclosure may improve on at least some of the challenges and issues described above by stacking multiple layers that include optical and electronic components to generate a vertically-stacked hybrid IC. Monocrystalline layers for forming the optical components are separately fabricated, and layer transfer is used to form a stack that includes multiple monocrystalline layers, so that optical components can be provided on multiple levels of the hybrid ID. For example, a first monocrystalline layer and a second monocrystalline layer are grown on separate substrates. Optical features including waveguides may be formed in or over the first monocrystalline layer. The second monocrystalline layer is attached to a carrier wafer, bonded to the first monocrystalline layer, and the carrier wafer is removed. Optical features including waveguides may then be formed in or over the second monocrystalline layer, providing a second optical layer. One or both of the optical layers may also include electronic components, or electronic components may be formed in one or more separate electronic layers. A bonding material having a lower crystallinity (e.g., a polycrystalline material), or no crystal structure (e.g., an amorphous material), may bond at least some of the layers. In addition, isolation layers are included in the stacked structure to prevent leakage of optical signals from the waveguides. The isolation layers have a different index of refraction from the optical waveguides.

The isolation layers and electronic layers may be formed using deposition or layer transfer. In general, vertically-stacked hybrid ICs may have various arrangements of waveguide layers, isolation layers, electronic layers, and bonding layers. Any of these layers may include multiple sublayers, e.g., an electronic layer may include a full metal stack with multiple layers.

For purposes of explanation, specific numbers, materials and configurations are set forth in order to provide a thorough understanding of the illustrative implementations. However, it will be apparent to one skilled in the art that the present disclosure may be practiced without the specific details or/and that the present disclosure may be practiced with only some of the described aspects. In other instances, well-known features are omitted or simplified in order not to obscure the illustrative implementations.

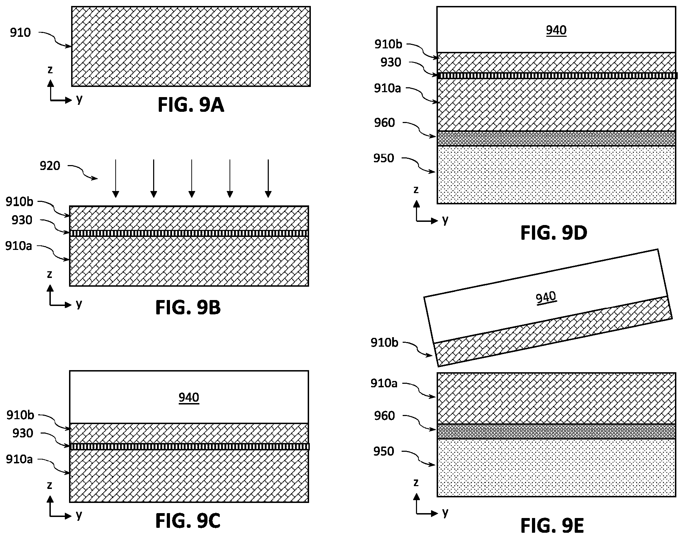

Further, references are made to the accompanying drawings that form a part hereof, and in which is shown, by way of illustration, embodiments that may be practiced. It is to be understood that other embodiments may be utilized, and structural or logical changes may be made without departing from the scope of the present disclosure. Therefore, the following detailed description is not to be taken in a limiting sense. For convenience, if a collection of drawings designated with different letters are present, e.g., FIGS. 9A-9E, such a collection may be referred to herein without the letters, e.g., as "FIG. 9."

In the drawings, some schematic illustrations of example structures of various devices and assemblies described herein may be shown with precise right angles and straight lines, this is simply for ease of illustration, and embodiments of these assemblies may be curved, rounded, or otherwise irregularly shaped as dictated by, and sometimes inevitable due to, the manufacturing processes used to fabricate semiconductor device assemblies. Therefore, it is to be understood that such schematic illustrations may not reflect real-life process limitations which may cause the features to not look so "ideal" when any of the structures described herein are examined using e.g., scanning electron microscopy (SEM) images or transmission electron microscope (TEM) images. In such images of real structures, possible processing defects could also be visible, e.g., not-perfectly straight edges of materials, tapered vias or other openings, inadvertent rounding of corners or variations in thicknesses of different material layers, occasional screw, edge, or combination dislocations within the crystalline region, and/or occasional dislocation defects of single atoms or clusters of atoms. There may be other defects not listed here but that are common within the field of device fabrication. Furthermore, although a certain number of a given element may be illustrated in some of the drawings (e.g., a certain number and type of interconnects and waveguides in the first and second IC structures of the IC assemblies illustrated in some drawings, a certain number of dies in the IC packages illustrated in other drawings, etc.), this is simply for ease of illustration, and more, or less, than that number may be included in IC assemblies and related devices according to various embodiments of the present disclosure. Still further, various views shown in some of the drawings are intended to show relative arrangements of various elements therein. In other embodiments, various IC assemblies, or portions thereof, may include other elements or components that are not illustrated. Inspection of layout and mask data and reverse engineering of parts of a device to reconstruct the circuit using e.g., optical microscopy, TEM, or SEM, and/or inspection of a cross-section of a device to detect the shape and the location of various device elements described herein using e.g., physical failure analysis (PFA) would allow determination of presence of one or more hybrid IC assemblies having multiple stacked layers as described herein.

Various operations may be described as multiple discrete actions or operations in turn, in a manner that is most helpful in understanding the claimed subject matter. However, the order of description should not be construed as to imply that these operations are necessarily order dependent. These operations may not be performed in the order of presentation. Operations described may be performed in a different order from the described embodiment. Various additional operations may be performed, and/or described operations may be omitted in additional embodiments.

For the purposes of the present disclosure, the phrase "A and/or B" means (A), (B), or (A and B). For the purposes of the present disclosure, the phrase "A, B, and/or C" means (A), (B), (C), (A and B), (A and C), (B and C), or (A, B, and C). The term "between," when used with reference to measurement ranges, is inclusive of the ends of the measurement ranges. Although certain elements may be referred to in the singular herein, such elements may include multiple subelements. For example, "an electrically conductive material" may include one or more electrically conductive materials.

The description uses the phrases "in an embodiment" or "in embodiments," which may each refer to one or more of the same or different embodiments. The terms "comprising," "including," "having," and the like, as used with respect to embodiments of the present disclosure, are synonymous. The disclosure may use perspective-based descriptions such as "above," "below," "top," "bottom," and "side" to explain various features of the drawings, but these terms are simply for ease of discussion, and do not imply a desired or required orientation. The accompanying drawings are not necessarily drawn to scale. Unless otherwise specified, the use of the ordinal adjectives "first," "second," and "third," etc., to describe a common object, merely indicate that different instances of like objects are being referred to, and are not intended to imply that the objects so described must be in a given sequence, either temporally, spatially, in ranking or in any other manner.

In the following detailed description, various aspects of the illustrative implementations will be described using terms commonly employed by those skilled in the art to convey the substance of their work to others skilled in the art.

For example, the term "interconnect" may be used to describe any element formed of an electrically conductive material for providing electrical connectivity to one or more components associated with an IC or/and between various such components. In general, the "interconnect" may refer to both conductive traces (also sometimes referred to as "lines" or "trench contacts") and conductive vias. In general, in context of interconnects, the term "conductive trace" may be used to describe an electrically conductive element isolated by an insulator material (e.g., a low-k dielectric material) that is provided within the plane of an IC die. Such traces are typically stacked into several levels, or several layers, of metallization stacks. On the other hand, the term "via" may be used to describe an electrically conductive element that interconnects two or more traces of different levels. To that end, a via may be provided substantially perpendicularly to the plane of an IC die and may interconnect two traces in adjacent levels or two traces in not adjacent levels. A term "metallization stack" may be used to refer to a stack of one or more interconnects for providing connectivity to different circuit components of an IC chip. Sometimes, traces and vias may be referred to as "conductive traces" and "conductive vias", respectively, to highlight the fact that these elements include electrically conductive materials such as metals.

Interconnects as described herein, in particular interconnects hybrid IC assemblies having multiple stacked layers as described herein, may be used for providing connectivity to one or more components associated with an IC or/and between various such components, where, in various embodiments, components associated with an IC may include, for example, transistors, diodes, power sources, resistors, capacitors, inductors, sensors, transceivers, receivers, antennas, etc. Components associated with an IC may include those that are mounted on IC or those connected to an IC. The IC may be either analog or digital and may be used in a number of applications, such as microprocessors, optoelectronics, logic blocks, audio amplifiers, etc., depending on the components associated with the IC. The IC may be employed as part of a chipset for executing one or more related functions in a computer.

In context of photonics, waveguides described herein may be considered a type of "interconnect" in that they support propagation of optical signals between various components associated with an IC and/or between various such components. Such interconnects may be referred to as "optical interconnects" to differentiate them from electrically conductive interconnects of electronic components, which may be referred to herein simply as "interconnects." Similarly, vias made of dielectric materials to serve as waveguides that support propagation of optical signals are described herein as "dielectric vias" to differentiate them from electrically conductive vias of electronic components, which may be described herein simply as "vias."

In another example, the terms "package" and "IC package" are synonymous, as are the terms "die" and "IC die," the term "insulating" means "electrically insulating," the term "conducting" means "electrically conducting," unless otherwise specified. Furthermore, the term "connected" may be used to describe a direct electrical or magnetic connection between the things that are connected, without any intermediary devices, while the term "coupled" may be used to describe either a direct electrical or magnetic connection between the things that are connected, or an indirect connection through one or more passive or active intermediary devices. The term "circuit" may be used to describe one or more passive and/or active components that are arranged to cooperate with one another to provide a desired function.

In yet another example, if used, the terms "oxide," "carbide," "nitride," etc. refer to compounds containing, respectively, oxygen, carbon, nitrogen, etc., the term "high-k dielectric" refers to a material having a higher dielectric constant than silicon oxide, while the term "low-k dielectric" refers to a material having a lower dielectric constant than silicon oxide.

The terms "substantially," "close," "approximately," "near," and "about," generally refer to being within +/- 20% of a target value based on the context of a particular value as described herein or as known in the art. Similarly, terms indicating orientation of various elements, e.g., "coplanar," "perpendicular," "orthogonal," "parallel," or any other angle between the elements, generally refer to being within +/- 5-20% of a target value based on the context of a particular value as described herein or as known in the art.

### Example IC with multiple stacked optical layers

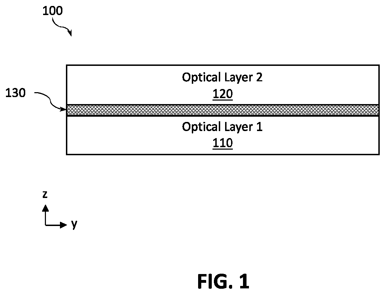

In general, hybrid IC assemblies with multiple stacked layers are described herein with reference to IC assemblies, such as the IC assemblies shown in FIGs. 1-3. FIG. 1 shows a stacked IC assembly having a first optical layer 110 and a second optical layer 120 bonded to one another using a bonding material 130. The optical layers 110 and 120 may be fabricated by different manufacturers, using different materials, or different manufacturing techniques.

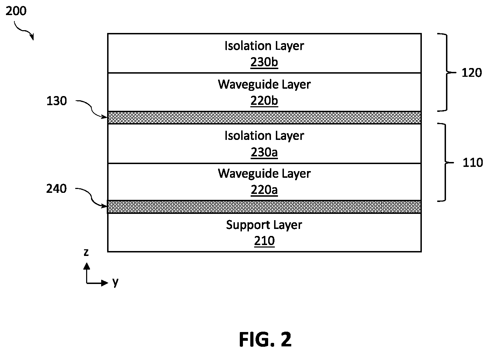

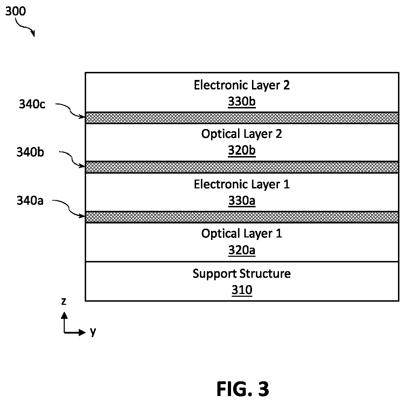

With respect to FIG. 1, the first optical layer 110 and second optical layers 120 are described as layers that include waveguides and other optical components, in order to described assemblies that include optical components in multiple layers. In some embodiments, one or both of the optical layers 110 and 120 may be hybrid assemblies that further include electronic components, such as electrically conductive interconnects, transistors, and resistors. Furthermore, the IC assembly 100 may include one or more electronics layers without optical components. While two optical layers 110 and 120 are depicted in FIG. 1, additional optical layers, electronic layers, and/or hybrid layers may be included, e.g., the IC assembly 100 may include three or more optical layers similar to the first optical layer 110 and/or second optical layer 120. An example IC assembly with both optical and electronic layers is shown in FIG. 2, and an example IC assembly with multiple hybrid layers is shown in FIG. 3.

FIG. 1 illustrates a cross-sectional side view of an IC assembly 100 with multiple stacked optical layers according to some embodiments of the present disclosure. The IC assembly 100 is an optical IC assembly, or photonic IC assembly (PIC), that includes two stacked optical layers 110 and 120, bonded by a bonding material 130.

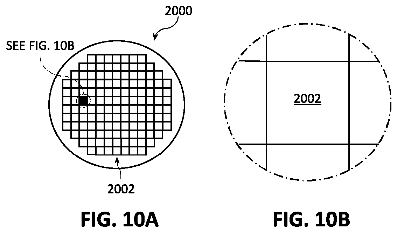

The IC assembly 100 may be formed or carried out on a support structure, not specifically shown in FIG. 1. The support structure may be included in the first optical layer 110 or below the first optical layer 110. The support structure may be, e.g., a substrate, a die, a wafer or a chip. The support structure may, e.g., be the wafer 2000 of FIG. 10A, discussed below, and may be, or be included in, a die, e.g., the singulated die 2002 of FIG. 10B, discussed below. The support structure may be a semiconductor substrate composed of semiconductor material systems including, for example, N-type or P-type materials systems. In one implementation, the semiconductor substrate may be a crystalline substrate formed using a bulk silicon or a silicon-on-insulator (SOI) substructure. In other implementations, the semiconductor substrate may be formed using alternate materials, which may or may not be combined with silicon, that include, but are not limited to, germanium, silicon germanium, indium antimonide, lead telluride, indium arsenide, indium phosphide, gallium arsenide, aluminum gallium arsenide, aluminum arsenide, indium aluminum arsenide, aluminum indium antimonide, indium gallium arsenide, gallium nitride, indium gallium nitride, aluminum indium nitride or gallium antimonide, or other combinations of group III-V materials (i.e., materials from groups III and V of the periodic system of elements), group II-VI (i.e., materials from groups II and IV of the periodic system of elements), or group IV materials (i.e., materials from group IV of the periodic system of elements). In some embodiments, the substrate may be non-crystalline. In some embodiments, the support structure may be a printed circuit board (PCB) substrate. Although a few examples of materials from which the substrate may be formed are described here, any material that may serve as a foundation upon which an optical device implementing any of the IC assemblies with multiple stacked layers as described herein may be built falls within the scope of the appended claims.

Each of the optical layers 110 and 120 includes waveguides for transmitting optical signals. Each optical layer may further include one or more other materials forming the boundaries of the waveguide and preventing leakage of optical signals from the waveguides; such materials may be referred to as cladding or isolation materials. Multiple isolation materials may be used along different edges or portions of a waveguide. For example, a waveguide having a rectangular cross-section may be formed over a first isolation layer, so a bottom face of the waveguide is coupled to the first isolation layer. A second isolation material may be deposited over the waveguide, so that the second isolation layer surrounds the sides and top face of the waveguide.

The waveguide material has a uniform crystal structure that allows an optical wave to propagate through the waveguide material with minimal loss. For example, the waveguide material may have grain size of at least 5 nanometers (nm). In some embodiments, the waveguide material has a larger minimum grain size, e.g., a grain size of at least 20nm, a grain size of at least 50 nm, or a grain size of at least 100 nm. The waveguides may be formed of any suitable single-crystal material, such as sapphire, quartz, silicon, a compound of silicon (e.g., silicon oxide), indium phosphide, germanium or a germanium alloy, gallium, arsenic (e.g., an arsenide III compound, where arsenic III is in combination with another element such as boron, aluminum, gallium, or indium), or any group III-V material (i.e., materials from groups III and V of the periodic system of elements).

The isolation material is a material without optical properties, or with different optical properties from the waveguide. For example, the isolation material may include a polycrystalline or amorphous silicon or silicon compound, such as silicon dioxide or silicon nitride. In some embodiments, the isolation material is a single-crystal material with different optical properties than the waveguide, e.g., a monocrystalline material (e.g., single-crystal silicon, gallium arsenide, or any of the other monocrystalline materials mentioned above) with a higher refractive index than the waveguide. In some embodiments, multiple isolation layers are formed of two or more different isolation materials.

The waveguide material may have a refractive index between 1.3 and 4, and an isolation material abutting at least a portion of the waveguide may have a different refractive index between 1.3 and 4. The waveguide material and isolation material may be selected such that the isolation material has a much higher or much lower refractive index than the waveguide material. In some embodiments, the isolation material and the waveguide material may have a similar or same refractive index. In such embodiments, an interface between the waveguide material and the isolation material may prevent leakage of signals into the isolation material, e.g., if the crystal structures of the waveguide material and the isolation material are different, or if the crystal structure restarts at the interface (e.g., if the isolation material and waveguide material are grown separately).

In some embodiments, one or more of the optical layers 110, 120 may further include photonic components to manipulate the optical signals, such as gain chips, diffraction gratings, combiners, demodulators, etc. The photonics components may include any of the waveguide materials described above. In some embodiments, one or more of the optical layers 110, 120 may include electro-optical components, e.g., an electro-optic modulator such as a Mach-Zehnder modulator or a ring oscillator.

The optical layers 110 and 120 are bonded together by a bonding layer 130. The bonding layer 130 is present in between the faces of the optical layers 110 and 120, e.g., above a front face of the optical layer 110 and below a back face of the optical layer 120. For each optical layer 110 and 120, the terms "bottom face" or "back face" of the structure may refer to the back of the structure, e.g., the face of the optical layer 120 along the bonding layer 130 is its bottom face, while the terms "top face" or "front face" of the structure may refer to the opposing upper face. The bonding material 130 may be applied to the one or both faces of the optical layers 110 and 120 that should be bonded and then the optical layers 110 and 120 are put together, possibly while applying a suitable pressure and heating up the assembly to a suitable temperature (e.g., to moderately high temperatures, e.g., between about 50 and 200 degrees Celsius) for a duration of time. An example illustration of a layer transfer process that can be used to bond the second optical layer 120 to the first optical layer 110 is shown in FIG. 10.

In some embodiments, the bonding material 130 may be an adhesive material that ensures attachment of the optical layers 110 and 120 to one another. In some embodiments, the bonding material 130 may be an etch-stop material. In some embodiments, the bonding material may be both an etch-stop material and have suitable adhesive properties to ensure attachment of optical layers 110 and 120 to one another. Such a bonding interface may be recognizable as a seam or a thin layer in the IC assembly 100, using, e.g., selective area diffraction (SED). The bonding material 130 has a lower crystallinity than one or more materials in each of the optical layers 110 and 120. The bonding material 130 has a lower crystallinity than the waveguides in the optical layers 110 and 120. For example, the bonding material 130 may have polycrystalline structure with a grain size of 20 nm or lower, e.g., a grain size between 1 nm and 20 nm. In some embodiments, the bonding material 130 has a grain size of 10 nm or lower, e.g., between 5 nm and 10 nm. In some embodiments, the bonding material 130 may have an amorphous structure. A polycrystalline or amorphous bonding material 130 is used to prevent optical leakage or transmission of optical signals along the bonding material 130. In some embodiments, the bonding material 130 is used as an isolation material, described above.

In some embodiments, the bonding material 130 may include silicon, nitrogen, and carbon, where the atomic percentage of any of these materials may be at least 1%, e.g., between about 1% and 50%, indicating that these elements are added deliberately, as opposed to being accidental impurities which are typically in concentration below about 0.1%. Using an etch-stop material that includes include silicon, nitrogen, and carbon, where the atomic percentage of any of these materials may be at least 1%, e.g., SiOCN, may be advantageous in terms that such a material may act both as an etch-stop material, and have sufficient adhesive properties to bond the first and second optical layers 110, 120 together. In addition, an etch-stop material at the interface between the first and second optical layers 110, 120 that includes include silicon, nitrogen, and carbon, where the atomic percentage of any of these materials may be at least 1%, may be advantageous in terms of improving etch-selectivity of this material with respect to etch-stop materials that may be used in different of the first and second optical layers 110, 120.

In some non-claimed embodiments, no bonding material 130 may be used, in which case the layer labeled "130" in FIG. 1 represents a bonding interface resulting from the bonding of the optical layers 110 and 120 to one another. Such a bonding interface may be recognizable as a seam or a thin layer in the IC assembly 100, using, e.g., SED; the bonding interface would still be noticeable as a seam or a thin layer in what otherwise appears as an isolation layer or joined pair of isolation layers. As used herein, unless specified otherwise, references to the "bonding material 130" are applicable to a "bonding interface" for the embodiments where no deliberately added adhesive material is used to bond the optical layers 110 and 120.

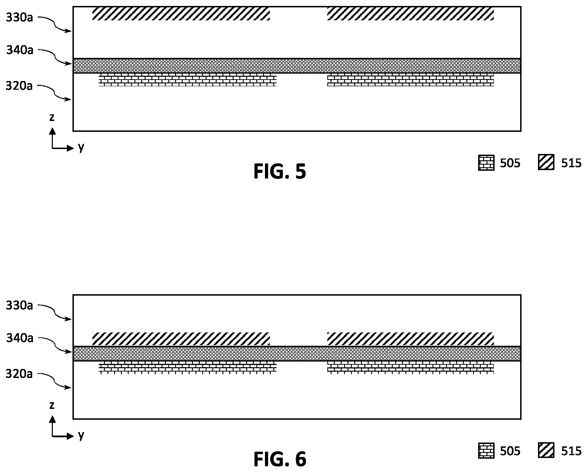

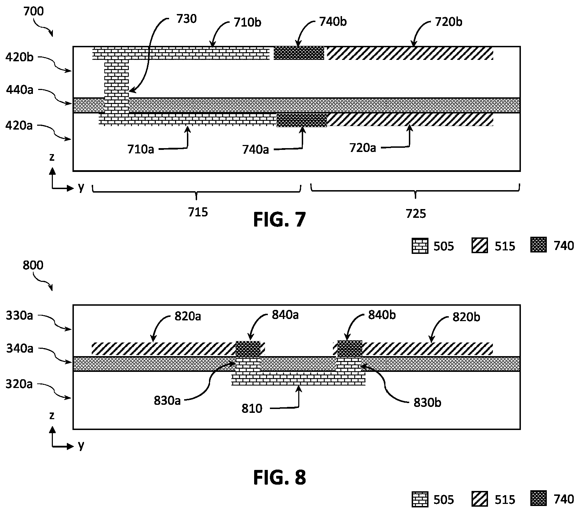

In some embodiments, the IC assembly 100 may include one or more dielectric vias, providing one or more dielectric pathways for guiding optical signals between the optical layers 110 and 120. The dielectric vias extend through the bonding material 130. Example dielectric vias are shown in FIGs. 6 and 7.

### Example Arrangements of Optical Layers

In a PIC or hybrid IC, waveguide layers and isolation layers may be stacked in various configurations. In general, each layer (e.g., a waveguide layer or an isolation layer) may either be deposited onto the layer below (e.g., a waveguide layer deposited on an isolation layer), or fabricated separately and transferred onto the layer below using a layer transfer process. As noted above, the waveguide material is monocrystalline. The isolation material for the waveguides may be monocrystalline, or it may have a different structure, e.g., polycrystalline or amorphous. Furthermore, a single-crystal structure (e.g., a monocrystalline waveguide layer) may be deposited over another monocrystalline layer (e.g., a monocrystalline isolation layer). However, repeated deposition of monocrystalline layers typically results in defects in the higher layers. For example, a monocrystalline waveguide layer (e.g., single-crystal germanium) can be deposited over a monocrystalline base layer (e.g., a single-crystal silicon substrate). The waveguide layer may have some defects (e.g., grain boundaries), but the crystal size is sufficiently large to form waveguides that propagate optical signals with minimal losses. When light propagating through a waveguide passes through a grain boundary, the light diffracts and loses energy, which is undesirable. If subsequent single-crystal layers are deposited over the waveguide layer (e.g., a second silicon isolation layer, followed by a second germanium waveguide layer), these layers can have decreasing crystal sizes and more grain boundaries, which make them unsuitable for waveguides. Therefore, to create a layered IC structure with sufficiently monocrystalline waveguides, at least some of the layers (e.g., isolation and/or waveguide layers) are stacked using a layer transfer process.

FIG. 2 provides a schematic illustration of an example embodiment of an IC assembly 200 with multiple optical layers. In this example, a support layer 210 forms the base of the IC assembly 200. The support layer 210 may be, e.g., a substrate, a die, a wafer, or a chip. The support layer 210 may be the wafer 2000 of FIG. 10A, discussed below, and may be, or be included in, a die, e.g., the singulated die 2002 of FIG. 10B, discussed below. The support layer 210 may be formed of any material, such as the support structure materials described with respect to FIG. 1.

The first optical layer 110 is formed over the support layer 210. The first optical layer 110 includes a waveguide layer 220a and an isolation layer 230a. The second optical layer 120 is formed over the first optical layer 110, and the second optical layer 120 is bonded to the first optical layer 110 by the bonding material 130. The second optical layer 120 includes a waveguide layer 220b and an isolation layer 230b. In this example, the waveguide layers 220a and 220b of the first and second optical layers 110 and 120 are similar, e.g., formed of the same material and using a similar process. The waveguide layers 220a and 220b are referred to generally as waveguide layers 220. In other examples, the waveguide layers 220a and 220b may be different, e.g., formed of different materials. In this example, the isolation layers 230a and 230b of the first and second optical layers 110 and 120 are similar, e.g., formed of the same material and using a similar process. The isolation layers 230a and 230b are referred to generally as isolation layers 230. In other examples, the isolation layers 230a and 230b may be different, e.g., formed of different materials. While two optical layers 110 and 120 are shown in FIG. 2, in other embodiments, one or more additional optical layers may be formed over the second optical layer 120, each including a waveguide layer 220 and an isolation layer 230.

A bonding layer 240 bonds the first optical layer 110, and in particular, the waveguide layer 220a, to the support layer 210. The bonding layer 240 may be similar to the bonding layer 130, described with respect to FIG. 1. The waveguide layer 220a is transferred onto the support layer 210 using a layer transfer process, such as the process shown in FIG. 6. The bonding material 240 may be applied to the back face of the waveguide layer 220a, to the front face of the support layer 210, or to both. The waveguide layer 220b is also transferred onto the first optical layer 110, and in particular, over the isolation layer 230a, using the layer transfer process. The bonding material 130 may be applied to the back face of the waveguide layer 220b, to the front face of the isolation layer 230a, or to both.

The waveguide layers 220a and 220b are fabricated separately from the IC assembly 200 and transferred onto the IC assembly 200, i.e., over the support layer 210 and isolation layer 230a, respectively. For example, each waveguide layer 220 is formed from an upper portion of a single-crystal silicon wafer or die, or each waveguide layer 220 is a single-crystal layer formed over a separate single-crystal substrate. Fabricating the waveguide layers 220 separately ensures that the waveguide layers 220 have a monocrystalline structure with minimal grain boundaries. The waveguide layers 220 are transferred as sheets of monocrystalline material. After each waveguide layer 220 is transferred, the waveguide layer 220 is patterned and etched to form various optical structures, such as waveguides and other optical features.

After the optical structures have been formed in a given waveguide layer 220, an isolation layer 230 is formed over the waveguide layer 220 using deposition (e.g., the isolation layer 230a is deposited over the waveguide layer 220a). The isolation layers 230 may be made of any material, including non-optical monocrystalline material, polycrystalline material, or amorphous material. While a single isolation layer 230 is shown in each optical layer 110 and 120, in some embodiments, the isolation layers 230 are formed from multiple layers. For example, the isolation layer 230a may include a first material that encloses the waveguide features, and a second material that is layered over the first material. A front face of the first isolation layer 230a may be smoothed (e.g., by grinding and polishing) to provide a suitable surface for layer transferring the second waveguide layer 220b.

FIG. 2 depicts the first optical layer 110 as including the waveguide layer 220a and isolation layer 230a, and the second optical layer 120 as including the waveguide layer 220b and the isolation layer 230b. While each optical layer 110 and 120 includes one waveguide layer 220, the isolation layers 230 and bonding layers 130 and 240 may be considered parts of different optical layers from the depiction in FIG. 2. For example, the support layer 210 may be considered part of the first optical layer 110. As another example, the isolation layer 230a may be considered part of the second optical layer 120, or part of both the first optical layer 110 and the second optical layer 120 (e.g., a back portion of the isolation layer 230a is part of the first optical layer 110, and a front portion of the isolation layer 230a and the bonding material 130 are part of the second optical layer 120).

The optical layers 110 and 120 may have other arrangements than the arrangements shown in FIG. 2. In the example shown in FIG. 2, the first waveguide layer 220a is layer transferred over the support layer 210. In an alternate embodiment, the support layer 210 is formed of a monocrystalline material, e.g., a single-crystal silicon, or a single-crystal gallium arsenide (GaAs), and the first waveguide layer 220a is deposited over the support layer 210. For example, the support layer 210 and waveguide layer 220a may be a silicon-on-insulator (SOI) wafer, e.g., the waveguide layer 220a is a single-crystal silicon layer formed over a single-crystal insulator, such as sapphire, that acts as the support layer 210. In such embodiments, optical features, including waveguides, are formed from the upper silicon layer of the SOI wafer.

In another embodiment, each of the waveguide layers 220 and isolation layers 230 are layer transferred onto the IC assembly and separated by a bonding layer 130. In still another embodiment, isolation layers are layer transferred onto the IC assembly and separated from the waveguide layers below by a bonding layer, and the waveguide layers are deposited over the isolation layers. In this embodiment, the isolation layers are formed of a monocrystalline material so that the waveguide layers, deposited over the isolation layers, have a single-crystal structure with sufficient uniformity to create optical features.

### Example Hybrid IC with multiple stacked optical layers

FIG. 3 provides a schematic illustration of a first hybrid IC assembly 300 with stacked electronic layers and optical layers, according to some embodiments of the present disclosure. The hybrid IC assembly 300 includes a support structure 310, two stacked optical layers 320a and 320b (referred to jointly as optical layers 320), and two electronic layers 330a and 330b (referred to jointly as electronic layers 330). The optical layers 320 and electronic layers 330 are bonded by layers of bonding material 340a, 340b, and 340c (referred to jointly as bonding material 340).

The support structure 310 supports optical layer 1 320a and the layers formed above optical layer 1 320a. The support structure 310 may be, e.g., a substrate, a die, a wafer or a chip. The support structure 310 may be similar to the support structure described with respect to FIG. 1 or the support layer 210 shown in FIG. 2.

Optical layer 1 320a is formed over the support structure 310. In this example, optical layer 1 320a is shown as being formed directly over the support structure 310, without a bonding layer 340. For example, the support structure 310 and a waveguide portion of optical layer 1 320a may be formed using a silicon-on-insulator (SOI) wafer, e.g., the waveguide material for optical layer 1 320a is a single-crystal silicon layer formed over a single-crystal insulator, such as sapphire, that acts as the support structure 310. In such embodiments, optical features, including waveguides, are formed from the upper silicon layer of the SOI wafer. In other embodiments, a bonding layer may be present between the support structure 310 and optical layer 1 320a. In some embodiments, one or more additional layers, such as the isolation layers 230 described with respect to FIG. 2, may be formed over the waveguide layer, and considered part of the optical layer 320a. The optical layers 320 may generally have a structure similar to the optical layers described with respect to FIG. 2, e.g., optical layer 1 310a includes a waveguide layer formed of a monocrystalline material and one or more isolation layers formed of different materials with different optical properties from the monocrystalline material forming the waveguide. As described with respect to FIG. 2, in different embodiments, an isolation layer may be deposited or layer transferred over the waveguide layer.

Electronic layer 1 330a is formed over optical layer 1 320a. In this example, a bonding layer 340a bonds an upper face of optical layer 1 320a to a lower face of electronic layer 1 330a. This may indicate that a layer transfer process, e.g., the layer transfer process described with respect to FIG. 10, is used to transfer at least some portion of electronic layer 1 330a over optical layer 1 320a. For example, a semiconductor material may be layer transferred over optical layer 1 320a, and transistors or other electronic features formed in or over the semiconductor material using known processing methods. The electronics layers 330 may include additional layers of material not specifically shown in FIG. 3, such as one or more metal layers for delivering power and routing signals to transistors; one or more memory layers (e.g., one capacitor layer and one transistor layer, where each capacitor is coupled to a respective transistor, referred to as an access transistor, to form a 1T-1C memory cell), or other electronic features known in the art. Each electronic layer 330 may include one or more layers that are deposited onto the IC assembly 300 and/or one or more layers that are layer transferred onto the IC assembly 300. In some embodiments, there is no bonding layer 340 between an optical layer 320 and the electronic layer 330 formed above it (e.g., between optical layer 1 320a and electronic layer 1 330a). For example, if an upper isolation layer of optical layer 1 320a is a monocrystalline material that is layer transferred over the waveguide layer, a monocrystalline semiconductor layer for forming electronic layer 1 330a may be deposited over the isolation layer.

In the example shown in FIG. 3, optical layer 2 320b is formed over electronic layer 1 330a. A bonding layer 340b separates optical layer 2 320b from electronic layer 1 330a and bonds optical layer 2 320b to electronic layer 1 330a. As noted above, in a stacked IC assembly, layer transfer is used to provide a monocrystalline material to form waveguides, or to provide a base layer (e.g., an isolation layer) of a monocrystalline material over which another monocrystalline layer for forming the waveguides may be deposited. Therefore, a bonding layer 340b is present in the IC assembly 300 either directly below, or one layer below, the waveguide layer of optical layer 2 320b. Electronic layer 2 330b is formed over optical layer 2 320b. Electronic layer 2 330b may be similar to electronic layer 1 330a.

While the hybrid IC assembly 300 includes two optical layers 320 and two electronic layers 330, any number of optical layers 320 and electronic layers 330 may be included, and in any order. For example, while optical layer 1 320a is the first layer over the support structure 310, in another embodiment, an electronic layer 330 may be the first layer over the support structure 310. While the optical layers 320 and electronic layers 330 are arranged in an alternating fashion, in other embodiments, two or more optical layers 320 may be arranged adjacent to each other without an intervening electronic layer 330, or two or more electronic layers 330 may be arranged adjacent to each other without an intervening electronic layer 330. The hybrid IC assembly 300 may include different numbers of optical layers 320 and electronic layers 330.

In FIG. 3, electronic features and optical features are included in separate layers. In some embodiments, one or more layers may include both electronic features and optical features. For example, one region of a layer includes optical features, and another region of the same layer includes electronic features. A layer that includes both electronic elements (e.g., transistors, resistors, capacitors, electrically conductive interconnects, etc.) and optical elements (e.g., waveguides, gain chips, diffraction gratings, combiners, demodulators, etc.) is referred to as a hybrid layer. A hybrid layer may further contain electro-optical components that include both optical and electronic elements, e.g., an electro-optic modulator such as a Mach-Zehnder modulator or a ring oscillator.

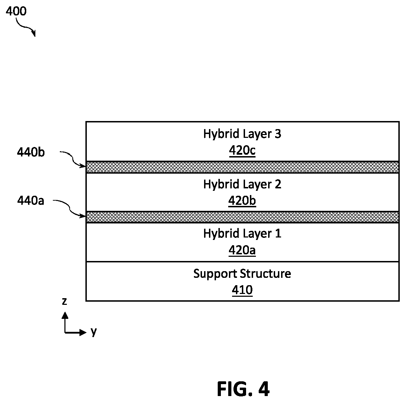

FIG. 4 provides a schematic illustration of a second hybrid IC assembly 400 with multiple stacked hybrid layers, according to some embodiments of the present disclosure. The hybrid IC assembly 400 includes a support structure 410 and three stacked hybrid layers 420a, 420b, and 420c (referred to jointly as hybrid layers 420). The hybrid layers 420 are bonded together by layers of bonding material 440a and 440 (referred to jointly as bonding material 440).

The support structure 410 supports hybrid layer 1 420a and the layers formed above hybrid layer 1 420a. The support structure 410 may be, e.g., a substrate, a die, a wafer or a chip. The support structure 410 may be similar to the support structure described with respect to FIG. 1 or the support layer 210 shown in FIG. 2.

Hybrid layer 1 420a is formed over the support structure 410. In this example, hybrid layer 1 420a is shown as being formed directly over the support structure 410, without a bonding layer 440. For example, the support structure 410 and a base portion of hybrid layer 1 420a may be formed using a silicon-on-insulator (SOI) wafer, e.g., the waveguide material for hybrid layer 1 420a is a single-crystal silicon layer formed over a single-crystal insulator, such as sapphire, that acts as the support structure 410. In such embodiments, optical features, including waveguides, are formed from the upper silicon layer of the SOI wafer. Single-crystal silicon is also a semiconductor that can be used to form electronic features, such as transistors, in hybrid layer 1 420a. In other embodiments, a bonding layer may be present between the support structure 410 and optical layer 1 320a, e.g., if a sheet of single-crystal silicon or other monocrystalline material is layer-transferred over the support structure 410.

One or more regions of the monocrystalline material are used to form optical structures including waveguides, and one or more other regions of the monocrystalline material may be used to form electronic features such as transistors. In some embodiments, a portion of the monocrystalline material used to form electronic features is doped with an n-type or p-type material. In some embodiments, one or more additional layers, such as the isolation layers 230 described with respect to FIG. 2, may be formed over the optical regions; these layers may be considered part of the hybrid layer 420a. The optical portions of the hybrid layers 420 may generally have a structure similar to the optical layers described with respect to FIG. 2. As described with respect to FIG. 2, in different embodiments, an isolation layer may be deposited or layer transferred over the waveguide layer. Furthermore, one or more additional layers, such as insulator (e.g., oxide), conductive layers (e.g., metal layers to form contacts, vias interconnects, and/or trench interconnects), and/or semiconductor layers may be formed in the electronic regions to form electronic portions of the hybrid layers 420.

While FIG. 3 shows a hybrid IC assembly 300 with separate optical layers 320 and electronic layers 330, and FIG. 4 shows a hybrid IC assembly 400 with hybrid layers 420, in other embodiments, a hybrid IC assembly may include one or more hybrid layers 420 along with one or more dedicated optical layers 320 and/or one or more dedicated electronic layers 330.

### Example Cross-Sections of Hybrid ICs with Optical Layers and Electronic Layers

FIG. 5 is a first illustration of a cross-section of an electronic layer stacked over an optical layer, according to some embodiments of the present disclosure. The cross-section includes an optical layer 320a, corresponding to optical layer 1 320a shown in FIG. 3; an electronic layer 330a, corresponding to electronic layer 1 330a shown in FIG. 3; and a bonding material 340a, also shown in FIG. 3, attaching the electronic layer 330a to the optical layer 320a. Optical structures 505 and electronic structures 515 are represented in FIG. 5 with the shadings shown in the legend.

The optical structures 505 are formed at or near a front side of the optical layer 320a, e.g., over an isolation layer. While not specifically shown in FIG. 5, the optical structures 505 may include waveguide structures and one or more other optical features, such as the features described above. The region below the optical structures 505 may include a support structure, e.g., the optical structures 505 may be formed in a top portion of an SOI wafer, as described above. The bonding material 340a and/or a lower portion of the electronic layer 330a may provide isolation along the front sides of the optical structures 505 (i.e., along the side of the optical structures 505 adjacent to the bonding material 340a), or an additional isolation layer not shown in FIG. 5 may be included above the optical structures 505.

In this example, the electronic structures 515 are formed at or near a front side of the electronic layer 330a, e.g., over an insulating material that has been layer transferred over the optical layer 320a. The electronic structures 515 may represent, for example, a transistor layer, a memory layer, or some other electronic layer. It should be understood that additional layers, including conductive layers forming vias, trenches, or other interconnect elements, may be included in the electronic layers 330. The interconnect elements may extend above and/or below the electronic structures 515 represented in FIG. 5. In some embodiments, conductive vias may extend through an optical layer 320a, e.g., to transfer data and/or power on or off the IC assembly. Conductive vias extending through the optical layer 320a may be in a separate region of the optical layer 320a from the optical structures 505, and the vias may not interact with the optical components of the optical layer 320a.

In this example, the electronic structures 515 are shown as being physically separated from the optical structures 505. Electronic elements produce heat that can influence the optical properties within the optical structures 505, e.g., by changing the permittivity of the waveguide material, and altering how optical signals propagate through the waveguide (and in particular, how well different frequencies of light propagate through the waveguide). If the electronic structures 515 are operating independently from the optical structures 505, and heat-based effects in the optical structures 505 are not desired, separating the electronic structures 515 from the optical structures 505 may be helpful.

In this example, the optical structures 505 and electronic structures 515 are both formed on the front sides if their respective layers 320 and 330. To further increase the distance between the electronic structures 515 and the optical structures 505, the optical structures 505 may be formed near the back side of the optical layer 320a. However, if multiple optical layers 320 and electronic layers 330 are alternately stacked, e.g., as shown in FIG. 3, this may result in an electronic layer below the optical layer 320a producing heat near the optical structures 505.

FIG. 6 is a second illustration of a cross-section of an electronic layer stacked over an optical layer, according to some embodiments of the present disclosure. The cross-section includes the optical layer 320a, corresponding to optical layer 1 320a shown in FIG. 3; the electronic layer 330a, corresponding to electronic layer 1 330a shown in FIG. 3; and a bonding material 340a, also shown in FIG. 3, attaching the electronic layer 330a to the optical layer 320a. Optical structures 505 and electronic structures 515 are represented in FIG. 6 with the shadings shown in the legend.

In this example, the optical structures 505 are formed at or near a front side of the optical layer 320a, e.g., over an isolation layer. The optical structures 505 and optical layer 320a may be similar to the optical layer 320a described with respect to FIG. 5. While not specifically shown, an isolation layer may be included above the optical structures 505.

Unlike in FIG. 5, the electronic structures 515 in FIG. 6 are formed at or near a back side of the electronic layer 330a, e.g., directly over the bonding layer 340a. In this example, the electronic structures 515 may include conductive features that produce heat used to modulate signals in the waveguide structures 505. As noted above, heat that can influence the optical properties within the optical structures 505; such heat-producing elements can be used to augment and/or control optical features, e.g., to create a tunable optical filter. Providing the electronic structures 515 closer to the optical structures 505 allows heat from the electronic structures 515 to more readily reach the optical structures 505, with lower energy consumption.

As with FIG. 5, it should be understood that additional layers, including conductive layers forming vias, trenches, or other interconnect elements, may be included in the electronic layers 330, and that interconnect elements may extend above and/or below the electronic structures 515 represented in FIG. 6, including conductive elements extending through the optical layer 320a.

### Example Cross-Sections of Hybrid ICs with Optical Connections

In some implementations, hybrid IC assemblies may be configured to provide primarily electronic-based (e.g., transistor-based) logic and/or memory, with optical communication pathways enabling communication between groups of electronic structures, including between multiple groups of electronic structures on the IC, or between electronic structures on other connected devices. As noted above, optical channels, e.g., waveguides, can enable signal transmission at higher bandwidth than typical electronic channels, e.g., metal trenches and vias. To increase bandwidth in a hybrid IC, one or more groups of electronic structures can be coupled to an electro-optical conversion component to convert between electronic signals and optical signals. This allows data from electronic structures to be transmitted through an optical structure and/or allows electronic structures to receive data through the optical structure.

FIG. 7 is an illustration of a cross-section of a hybrid IC assembly 700 with two stacked hybrid layers connected by an optical via, according to some embodiments of the present disclosure. The cross-section includes a first hybrid layer 420a, corresponding to hybrid layer 1 420a shown in FIG. 4; a second hybrid layer 420b, corresponding to hybrid layer 2 420b shown in FIG. 4; and a bonding material 440a, also shown in FIG. 4, attaching the two hybrid layers 420a and 420b. One or more additional hybrid layers (e.g., hybrid layer 3 420c shown in FIG. 4), or dedicated optical and/or electronic layers (such as those described above), may be included in the assembly 700. Two groups of optical structures 710a and 710b and two groups of electronic structures 720a and 720b are represented in FIG. 7 with the shadings shown in the legend; the shadings 505 and 515 correspond to the optical structures and electronic structures shown in FIGs. 5 and 6.

In this example, each hybrid layer 420 includes both optical structures 710 and electronic structures 720, e.g., the first hybrid layer 420a includes a group of optical structures 710a and a group of electronic structures 720a. Each group of optical structures 710 is formed in an optical portion 715 of the assembly, and each group of electronic structures 720 is formed in an electronic portion 725 of the assembly. In this example, the optical portions 715 and electronic portions 725 are stacked over each other (e.g., the optical structures 710b are stacked over the optical structures 710a), but in other examples, each hybrid layer 420 may have optical structures 710 and electronic structures 720 in different portions, e.g., the group of optical structures 710b may be stacked over the group of electronic structures 720a. The groups of electronic structures 720a and 720b may be considered different electronic regions of the hybrid IC assembly 700.

An optical via 730 is coupled to the groups of optical structures 710a and 710b to carry optical signals between the groups of optical structures 710a and 710b, e.g., from the first group of optical structures 710a to the second group of optical structures 710b and/or from the second group of optical structures 710b to the first group of optical structures 710a. The optical via 730 extends through the bonding material 440a. While one optical via 730 is shown in FIG. 7, multiple optical vias connecting the groups of optical structures 710a and 710b may be included, e.g., to provide communication pathways in two directions, or to increase bandwidth between the optical structures 710a and 710b.

In this example implementation, the hybrid IC assembly 700 shown in FIG. 7, and in particular, the electronic structures 720, may provide primarily electronic-based (e.g., transistor-based) logic and/or memory, with the optical structures 710 and optical via 730 enabling communication between groups of electronic structures 720. Each group of electronic structures 720a and 720b is coupled to a respective conversion circuitry 740a or 740b, which converts electronic signals to optical signals (or vice versa) so that data between the groups of electronic structures 720a and 720b may be transmitted through the optical structures 710 and the optical via 730.

For example, if the optical via 730 transmits signals from the optical structures 710a to the optical structures 710b, the conversion circuitry 740a receives signals (e.g., digital signals represented by two different voltage levels) and converts them to optical signals (e.g., a light wave modulated to represent the digital signals, e.g., using frequency, amplitude, and/or phase modulation) for transmission through the optical structures 710a, through the optical via 730, and to the optical structures 710b. The conversion circuitry 740b receives the optical signals and converts the optical signals to digital electronic signals received by the electronic structures 720b.

While the optical vias 730, optical structures 710, and conversion circuitry 740 are represented as connecting two groups of electronic structures 720 in the same hybrid IC assembly 700, in some embodiments, optical structures (e.g., conversion circuitry and waveguides) may be configured to communicate signals on and/or off the hybrid IC assembly, e.g., to form optical communication pathways to one or more devices coupled to the hybrid IC assembly. For example, an optical waveguide may be coupled between some electronic structures (e.g., the second group of electronic structures 720b) and an optical port on the hybrid IC assembly 700 to transfer signals off the hybrid IC assembly 700 and/or onto the hybrid IC assembly 700.

In the example shown in FIG. 7, the optical structures 710 are formed at or near the front sides of the hybrid layers 420, e.g., over an isolation layer. The optical portion of each hybrid layer 420 (i.e., the portions including the optical structures 710) may formed in a similar manner to the optical layers 110 and 120 described with respect to FIG. 2 or the optical layers 320 described with respect to FIG. 5. While not specifically shown in FIG. 7, an isolation layer may be included within the hybrid layers 420 above the optical structures 710.

In addition, the electronic structures 720 are depicted as being formed at or near a front side of each hybrid layer 420, e.g., over an insulating material. The electronic structures 720 may be similar to the electronic structures 515 described with respect to FIG. 5. As with FIG. 5, it should be understood that additional layers, including conductive layers forming vias, trenches, or other interconnect elements, may be included in the hybrid layer 420, and that interconnect elements may extend above and/or below the electronic structures 720 represented in FIG. 7. For example, in addition to the optical via 730, conductive vias may extend through the bonding layer 440a and/or through the hybrid layers 420a and/or 420b, e.g., to transfer power to groups of electronic structures 720, or to transfer data and/or power on or off the IC assembly.

FIG. 8 is an illustration of a cross-section of a hybrid IC assembly 800 with an electronic layer stacked over an optical layer where the optical layer provides communication between two regions of the electronic layer, according to some embodiments of the present disclosure. In this example, the electronic layer includes two groups of electronic structures that are connected by an optical channel in the optical layer. The optical channel provides a high-bandwidth transmission pathway between the two groups of electronic structures.

The cross-section includes an optical layer 320a, corresponding to optical layer 1 320a shown in FIG. 3; an electronic layer 330a, corresponding to electronic layer 1 330a shown in FIG. 3; and a bonding material 340a, also shown in FIG. 3, attaching the electronic layer 330a to the optical layer 320a. One or more additional electronic, waveguide, and/or hybrid layers may be included in the assembly 800. Optical structures 810 and two groups of electronic structures 820a and 820b are represented in FIG. 8 with the shadings shown in the legend; the shadings 505 and 515 correspond to the optical structures and electronic structures shown in FIGs. 5-7, and the shading 740 corresponds to the conversion circuitry shown in FIG. 7.

In this example, the two groups of electronic structures 820a and 820b may be considered different electronic regions of the electronic layer 330a, and more generally, different electronic regions of the hybrid IC assembly 800. A first optical via 830a and a first conversion circuitry 840a are coupled between the optical structures 810a and the first group of electronic structures 820a, and a second optical via 830b and a second conversion circuitry 840b are coupled between the optical structures 810 and the second group of electronic structures 810b. The conversion circuitries 840 converts electronic signals to optical signals (or vice versa) so that data between the groups of electronic structures 820a and 820b may be transmitted through the optical structures 810 and the optical vias 830a and 830b. The conversion circuitries 840, optical vias 830, and optical structures 810 may be considered an optical pathway between the two groups of electronic structures 820a and 820b. While one optical pathway is shown in FIG. 8, multiple optical pathways connecting the groups of electronic structures 820a and 820b, or to connect additional groups of electronic structures, may be included in the hybrid IC assembly 800, e.g., to provide communication pathways in two directions, or to increase bandwidth between the electronic structures.

In this example, the hybrid IC assembly 800, and in particular, the electronic structures 820 may provide primarily electronic-based (e.g., transistor-based) logic and/or memory, with the optical pathways enabling communication between groups of electronic structures 820.

While the optical vias 730, optical structures 710, and conversion circuitry 740 are represented as connecting two groups of electronic structures 720 in the same hybrid IC assembly 700, in some embodiments, optical structures (e.g., conversion circuitry and waveguides) may be configured to communicate signals on and/or off the hybrid IC assembly, e.g., to form optical communication pathways to one or more devices coupled to the hybrid IC assembly.

In the example shown in FIG. 8, the optical structures 810 are formed at or near the front side of the optical layers 320a, e.g., over an isolation layer. The optical layer 320 may formed in a similar manner to the optical layers 110 and 120 described with respect to FIG. 2 or the optical layers 320 described with respect to FIG. 5. While not specifically shown in FIG. 8, an isolation layer may be included in the optical layer 330a above the optical structures 810.

In addition, the electronic structures 720 are depicted as being formed at or near a back side of the electronic layer 330a. The electronic structures 820 may be similar to the electronic structures described with respect to FIG. 6. As with FIG. 6, it should be understood that additional layers, including conductive layers forming vias, trenches, or other interconnect elements, may be included in the electronic layer 330a, and that interconnect elements may extend above and/or below the electronic structures 820 represented in FIG. 8, as described with respect to FIGs. 5-7.

### Example Layer Transfer Process

FIG. 9A-9E illustrate an example layer transfer process for forming an IC assembly with multiple stacked optical layers. The illustrated layer transfer process may be used to fabricate any of the IC assemblies shown in FIGs. 1-8.

FIG. 9A illustrates a monocrystalline material 910, e.g., a monocrystalline material for forming a waveguide for an optical layer or optical region and/or single-crystal semiconductor for an electronic layer or electronic region. Alternatively, the monocrystalline material 910 may be used to form an isolation layer, e.g., an isolation layer over which a single-crystal waveguide material is deposited. While layer transfer of a monocrystalline material is depicted in FIG. 9, a similar process may be used to layer transfer other types of materials for use in any of the hybrid IC structures described herein, such as polycrystalline or amorphous material.

The monocrystalline material 910 is formed as a sheet that extends in an x-direction (into and/or out of the page) and in the y-direction, labelled in FIG. 9. The monocrystalline material 910 may have a height in the z-direction of up to 1 millimeter. While the monocrystalline material 910 is depicted as a single material having a single crystal structure, in some embodiments, the monocrystalline material 910 includes multiple layers of monocrystalline materials, e.g., a single-crystal silicon layer formed over a single-crystal sapphire layer. In such embodiments, the lower layer may be an isolation layer, such that an isolation layer and a waveguide layer are transferred onto an IC assembly in a single layer transfer process.

In FIG. 9B, a material 920 is implanted into a region 930 of the monocrystalline material 910. The implant material 920 weakens the implant region 930, e.g., by forming cracks in the implant region 930 of the monocrystalline material 910. The implant region 930 is formed as a layer between a lower portion 910a and an upper portion 910b of the monocrystalline material 910. The implant region 930 may be, e.g., between 50 nm and 500 nm from a front face of the monocrystalline material 910. In some embodiments, the implant material 920 is electrically inert and does not change the electrical properties of the monocrystalline material 910, e.g., the implant material 920 does not dope the monocrystalline material 910. The implant material 920 may be, for example, hydrogen, helium, nitrogen, or ammonium. In some embodiments, multiple implant materials 920 may be used. After the implant material 920 is implanted into the monocrystalline material 910, the monocrystalline material 910 may cured by applying heat for a period of time. The monocrystalline material 910 outside the region 930 (i.e., the upper portion 910b and lower portion 910a of the monocrystalline material) is not affected by the implant material 920, e.g., these portions 910a and 910b maintain the monocrystalline structure without cracks or other defects (or a minimal amount of defects).

In FIG. 9C, a carrier wafer 940 is bonded to the front face of the monocrystalline material 910, i.e., to the upper portion 910b of the monocrystalline material 910. A bonding material, not shown in FIG. 9, may be used to adhere the carrier wafer 940 to the monocrystalline material 910. In other embodiments, the monocrystalline material 910 is flipped, and the back face of the lower portion 910a is bonded to a carrier wafer 940.

In FIG. 9D, the back face of the monocrystalline material 910 (e.g., the base of the lower portion 910a) is bonded to an IC assembly 950 with a bonding material 960. The bonding material 960 may be any of the bonding materials described above, such as the bonding material 130 shown in FIG. 1, or the bonding materials 240, 340, or 440 shown in FIGs. 2, 3, or 4, respectively. The IC assembly 950 may be a lower portion (below the layer being transferred) of any of the IC assemblies shown in FIGs. 1-8. To bond the monocrystalline material 910 to the IC assembly 950 with the bonding material 960, a suitable pressure may be applied, or the assembly may be heated up to a suitable temperature (e.g., to moderately high temperatures, e.g., between about 50 and 200 degrees Celsius) for a duration of time.

In FIG. 9E, the carrier wafer 940 and the upper portion 910b of the monocrystalline material are lifted off the IC assembly 950, leaving the lower portion 910a attached to the IC assembly 950. The cracks formed in the implant region 930 cause the monocrystalline material 910 to break between the upper portion 910b and the lower portion 910a. In some embodiments, after the carrier wafer 940 and upper portion 910b of the monocrystalline material are removed, the exposed front surface of the lower portion 910a is grinded and/or polished to reduce the height of the lower portion 910a and/or to produce a smooth surface for forming the optical structures.

In alternate embodiments, e.g., if the monocrystalline material 910 is suitably thick and mechanically stable, the carrier wafer 940 is not used. Instead, the monocrystalline material 910 may be flipped to bond the back face of the lower portion 910b to the IC assembly 950, and the upper portion 910a is lifted off the IC assembly 950.

### Variations and implementations

Various device assemblies illustrated in FIGS. 1-9 do not represent an exhaustive set of stacked hybrid IC devices as described herein, but merely provide examples of such devices/structures/assemblies. In particular, the number and positions of various elements shown in FIGS. 1-9 is purely illustrative and, in various other embodiments, other numbers of these elements, provided in other locations relative to one another may be used in accordance with the general architecture considerations described herein.

Further, FIGS. 1-9 are intended to show relative arrangements of the elements therein, and the device assemblies of these figures may include other elements that are not specifically illustrated (e.g., various interfacial layers). Similarly, although particular arrangements of materials are discussed with reference to FIGS. 1-9, intermediate materials may be included in the IC devices and assemblies of these figures. Still further, although some elements of the various cross-sectional views are illustrated in FIGS. 1-9 as being planar rectangles or formed of rectangular solids, this is simply for ease of illustration, and embodiments of these assemblies may be curved, rounded, or otherwise irregularly shaped as dictated by, and sometimes inevitable due to, the manufacturing processes used to fabricate semiconductor device assemblies.

Inspection of layout and mask data and reverse engineering of parts of a device to reconstruct the circuit using e.g., optical microscopy, TEM, or SEM, and/or inspection of a cross-section of a device to detect the shape and the location of various device elements described herein using e.g., Physical Failure Analysis (PFA) would allow determination of presence of the stacked hybrid IC devices as described herein.

### Example devices

The three-dimensional transistors with recessed gates disclosed herein may be included in any suitable electronic device. FIGS. 10-13 illustrate various examples of apparatuses that may include one or more of the stacked hybrid IC devices disclosed herein.

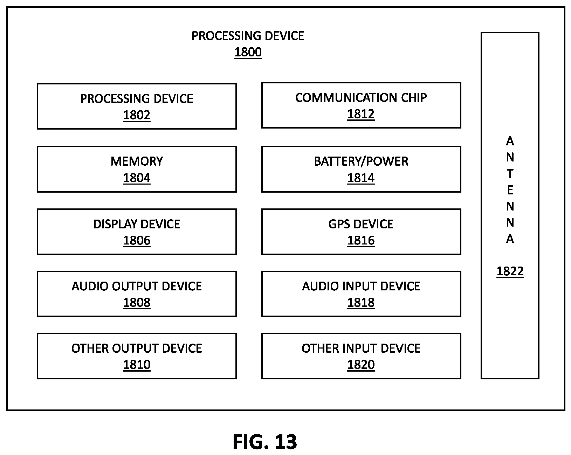

FIGS. 10A and 10B are top views of a wafer and dies that include one or more IC structures with stacked optical, electronic, and/or hybrid layers in accordance with any of the embodiments disclosed herein. The wafer 2000 may be composed of semiconductor material and may include one or more dies 2002 having IC structures formed on a surface of the wafer 2000. Each of the dies 2002 may be a repeating unit of a semiconductor product that includes any suitable IC structure (e.g., the IC structures as shown in any of FIGS. 1-9, or any further embodiments of the IC structures described herein). After the fabrication of the semiconductor product is complete (e.g., after manufacture of one or more IC structures with stacked optical, electronic, and/or hybrid layers as described herein, included in a particular electronic component, e.g., in a transistor or in a memory device), the wafer 2000 may undergo a singulation process in which each of the dies 2002 is separated from one another to provide discrete "chips" of the semiconductor product. In particular, devices that include one or more IC structures with stacked optical, electronic, and/or hybrid layers as disclosed herein may take the form of the wafer 2000 (e.g., not singulated) or the form of the die 2002 (e.g., singulated). The die 2002 may include one or more transistors (e.g., one or more of the transistors 1640 of FIG. 16, discussed below) and/or supporting circuitry to route electrical signals to the transistors, as well as any other IC components (e.g., one or more IC structures with stacked optical, electronic, and/or hybrid layers). In some embodiments, the wafer 2000 or the die 2002 may include a memory device (e.g., an SRAM device), a logic device (e.g., an AND, OR, NAND, or NOR gate), or any other suitable circuit element. Multiple ones of these devices may be combined on a single die 2002. For example, a memory array formed by multiple memory devices may be formed on a same die 2002 as a processing device (e.g., the processing device 1802 of FIG. 13) or other logic that is configured to store information in the memory devices or execute instructions stored in the memory array.

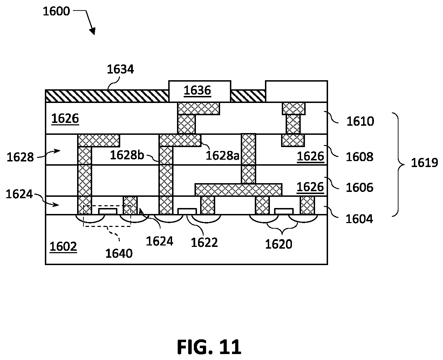

FIG. 11 is a cross-sectional side view of an IC device 1600 that may include one or more IC structures in accordance with any of the embodiments disclosed herein. The IC device 1600 may be formed on a substrate 1602 (e.g., the wafer 2000 of FIG. 10A) and may be included in a die (e.g., the die 2002 of FIG. 10B). The substrate 1602 may be any substrate as described herein. The substrate 1602 may be part of a singulated die (e.g., the dies 2002 of FIG. 10B) or a wafer (e.g., the wafer 2000 of FIG. 10A).

The IC device 1600 may include one or more device layers 1604 disposed on the substrate 1602. The device layer 1604 may include features of one or more transistors 1640 (e.g., metal oxide semiconductor field-effect transistors (MOSFETs)) formed on the substrate 1602. The device layer 1604 may include, for example, one or more source and/or drain (S/D) regions 1620, a gate 1622 to control current flow in the transistors 1640 between the S/D regions 1620, and one or more S/D contacts 1624 to route electrical signals to/from the S/D regions 1620. The transistors 1640 may include additional features not depicted for the sake of clarity, such as device isolation regions, gate contacts, and the like. The transistors 1640 are not limited to the type and configuration depicted in FIG. 11 and may include a wide variety of other types and configurations such as, for example, planar transistors, non-planar transistors, or a combination of both. Non-planar transistors may include FinFET transistors, such as double-gate transistors or tri-gate transistors, and wrap-around or all-around gate transistors, such as nanoribbon and nanowire transistors.

Each transistor 1640 may include a gate 1622 formed of at least two layers, a gate electrode layer and a gate dielectric layer.

The gate electrode layer may be formed on the gate interconnect support layer and may consist of at least one P-type workfunction metal or N-type workfunction metal, depending on whether the transistor is to be a PMOS or an NMOS transistor, respectively. In some implementations, the gate electrode layer may consist of a stack of two or more metal layers, where one or more metal layers are workfunction metal layers and at least one metal layer is a fill metal layer. Further metal layers may be included for other purposes, such as a barrier layer or/and an adhesion layer.

For a PMOS transistor, metals that may be used for the gate electrode include, but are not limited to, ruthenium, palladium, platinum, cobalt, nickel, and conductive metal oxides, e.g., ruthenium oxide. A P-type metal layer will enable the formation of a PMOS gate electrode with a workfunction that is between about 4.9 electron Volts (eV) and about 5.2 eV. For an NMOS transistor, metals that may be used for the gate electrode include, but are not limited to, hafnium, zirconium, titanium, tantalum, aluminum, alloys of these metals, and carbides of these metals such as hafnium carbide, zirconium carbide, titanium carbide, tantalum carbide, aluminum carbide, tungsten, tungsten carbide. An N-type metal layer will enable the formation of an NMOS gate electrode with a workfunction that is between about 3.9 eV and about 4.2 eV.

In some embodiments, when viewed as a cross section of the transistor 1640 along the source-channel-drain direction, the gate electrode may be formed as a U-shaped structure that includes a bottom portion substantially parallel to the surface of the substrate and two sidewall portions that are substantially perpendicular to the top surface of the substrate. In other embodiments, at least one of the metal layers that form the gate electrode may simply be a planar layer that is substantially parallel to the top surface of the substrate and does not include sidewall portions substantially perpendicular to the top surface of the substrate. In other embodiments, the gate electrode may be implemented as a combination of U-shaped structures and planar, non-U-shaped structures. For example, the gate electrode may be implemented as one or more U-shaped metal layers formed atop one or more planar, non-U-shaped layers. In some embodiments, the gate electrode may consist of a V-shaped structure (e.g., when a fin of a FinFET transistor does not have a "flat" upper surface, but instead has a rounded peak).

Generally, the gate dielectric layer of a transistor 1640 may include one layer or a stack of layers, and the one or more layers may include silicon oxide, silicon dioxide, and/or a high-k dielectric material. The high-k dielectric material included in the gate dielectric layer of the transistor 1640 may include elements such as hafnium, silicon, oxygen, titanium, tantalum, lanthanum, aluminum, zirconium, barium, strontium, yttrium, lead, scandium, niobium, and zinc. Examples of high-k materials that may be used in the gate dielectric layer include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate. In some embodiments, an annealing process may be carried out on the gate dielectric layer to improve its quality when a high-k material is used.

The S/D regions 1620 may be formed within the substrate 1602 adjacent to the gate 1622 of each transistor 1640, using any suitable processes known in the art. For example, the S/D regions 1620 may be formed using either an implantation/diffusion process or a deposition process. In the former process, dopants such as boron, aluminum, antimony, phosphorous, or arsenic may be ion-implanted into the substrate 1602 to form the S/D regions 1620. An annealing process that activates the dopants and causes them to diffuse farther into the substrate 1602 may follow the ion implantation process. In the latter process, an epitaxial deposition process may provide material that is used to fabricate the S/D regions 1620. In some implementations, the S/D regions 1620 may be fabricated using a silicon alloy such as silicon germanium or silicon carbide. In some embodiments, the epitaxially deposited silicon alloy may be doped in situ with dopants such as boron, arsenic, or phosphorous. In some embodiments, the S/D regions 1620 may be formed using one or more alternate semiconductor materials such as germanium or a group III-V material or alloy. In further embodiments, one or more layers of metal and/or metal alloys may be used to form the S/D regions 1620. In some embodiments, an etch process may be performed before the epitaxial deposition to create recesses in the substrate 1602 in which the material for the S/D regions 1620 is deposited.

Electrical signals, such as power and/or input/output (I/O) signals, may be routed to and/or from the transistors 1640 of the device layer 1604 through one or more interconnect layers disposed on the device layer 1604 (illustrated in FIG. 11 as interconnect layers 1606-1610). For example, electrically conductive features of the device layer 1604 (e.g., the gate 1622 and the S/D contacts 1624) may be electrically coupled with the interconnect structures 1628 of the interconnect layers 1606-1610. The one or more interconnect layers 1606-1610 may form an ILD stack 1619 of the IC device 1600.

The interconnect structures 1628 may be arranged within the interconnect layers 1606-1610 to route electrical signals according to a wide variety of designs (in particular, the arrangement is not limited to the particular configuration of interconnect structures 1628 depicted in FIG. 11). Although a particular number of interconnect layers 1606-1610 is depicted in FIG. 11, embodiments of the present disclosure include IC devices having more or fewer interconnect layers than depicted.

In some embodiments, the interconnect structures 1628 may include trench contact structures 1628a (sometimes referred to as "lines") and/or via structures 1628b (sometimes referred to as "holes") filled with an electrically conductive material such as a metal. The trench contact structures 1628a may be arranged to route electrical signals in a direction of a plane that is substantially parallel with a surface of the substrate 1602 upon which the device layer 1604 is formed. For example, the trench contact structures 1628a may route electrical signals in a direction in and out of the page from the perspective of FIG. 11. The via structures 1628b may be arranged to route electrical signals in a direction of a plane that is substantially perpendicular to the surface of the substrate 1602 upon which the device layer 1604 is formed. In some embodiments, the via structures 1628b may electrically couple trench contact structures 1628a of different interconnect layers 1606-1610 together.

The interconnect layers 1606-1610 may include a dielectric material 1626 disposed between the interconnect structures 1628, as shown in FIG. 11. The dielectric material 1626 may take the form of any of the embodiments of the dielectric material provided between the interconnects of the IC structures disclosed herein.

In some embodiments, the dielectric material 1626 disposed between the interconnect structures 1628 in different ones of the interconnect layers 1606-1610 may have different compositions. In other embodiments, the composition of the dielectric material 1626 between different interconnect layers 1606-1610 may be the same.

A first interconnect layer 1606 (referred to as Metal 1 or "M1") may be formed directly on the device layer 1604. In some embodiments, the first interconnect layer 1606 may include trench contact structures 1628a and/or via structures 1628b, as shown. The trench contact structures 1628a of the first interconnect layer 1606 may be coupled with contacts (e.g., the S/D contacts 1624) of the device layer 1604.

A second interconnect layer 1608 (referred to as Metal 2 or "M2") may be formed directly on the first interconnect layer 1606. In some embodiments, the second interconnect layer 1608 may include via structures 1628b to couple the trench contact structures 1628a of the second interconnect layer 1608 with the trench contact structures 1628a of the first interconnect layer 1606. Although the trench contact structures 1628a and the via structures 1628b are structurally delineated with a line within each interconnect layer (e.g., within the second interconnect layer 1608) for the sake of clarity, the trench contact structures 1628a and the via structures 1628b may be structurally and/or materially contiguous (e.g., simultaneously filled during a dual-damascene process) in some embodiments.

A third interconnect layer 1610 (referred to as Metal 3 or "M3") (and additional interconnect layers, as desired) may be formed in succession on the second interconnect layer 1608 according to similar techniques and configurations described in connection with the second interconnect layer 1608 or the first interconnect layer 1606.

The IC device 1600 may include a solder resist material 1634 (e.g., polyimide or similar material) and one or more bond pads 1636 formed on the interconnect layers 1606-1610. The bond pads 1636 may be electrically coupled with the interconnect structures 1628 and configured to route the electrical signals of the transistor(s) 1640 to other external devices. For example, solder bonds may be formed on the one or more bond pads 1636 to mechanically and/or electrically couple a chip including the IC device 1600 with another component (e.g., a circuit board). The IC device 1600 may have other alternative configurations to route the electrical signals from the interconnect layers 1606-1610 than depicted in other embodiments. For example, the bond pads 1636 may be replaced by or may further include other analogous features (e.g., posts) that route the electrical signals to external components.

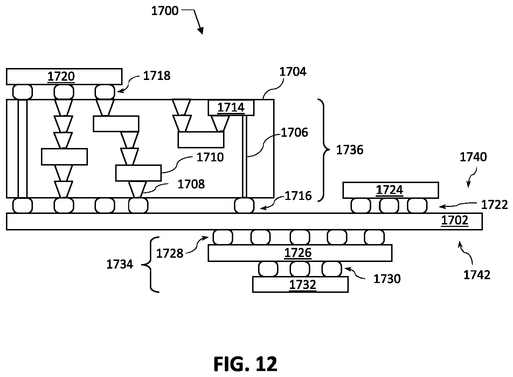

FIG. 12 is a cross-sectional side view of an IC device assembly 1700 that may include components having or being associated with (e.g., being electrically connected by means of) one or more IC structures with stacked optical, electronic, and/or hybrid layers in accordance with any of the embodiments disclosed herein. The IC device assembly 1700 includes a number of components disposed on a circuit board 1702 (which may be, e.g., a motherboard). The IC device assembly 1700 includes components disposed on a first face 1740 of the circuit board 1702 and an opposing second face 1742 of the circuit board 1702; generally, components may be disposed on one or both faces 1740 and 1742. In particular, any suitable ones of the components of the IC device assembly 1700 may include stacked optical, electronic, and/or hybrid layers, disclosed herein.

In some embodiments, the circuit board 1702 may be a printed circuit board (PCB) including multiple metal layers separated from one another by layers of dielectric material and interconnected by electrically conductive vias. Any one or more of the metal layers may be formed in a desired circuit pattern to route electrical signals (optionally in conjunction with other metal layers) between the components coupled to the circuit board 1702. In other embodiments, the circuit board 1702 may be a non-PCB substrate.

The IC device assembly 1700 illustrated in FIG. 12 includes a package-on-interposer structure 1736 coupled to the first face 1740 of the circuit board 1702 by coupling components 1716. The coupling components 1716 may electrically and mechanically couple the package-on-interposer structure 1736 to the circuit board 1702 and may include solder balls (as shown in FIG. 12), male and female portions of a socket, an adhesive, an underfill material, and/or any other suitable electrical and/or mechanical coupling structure.

The package-on-interposer structure 1736 may include an IC package 1720 coupled to an interposer 1704 by coupling components 1718. The coupling components 1718 may take any suitable form for the application, such as the forms discussed above with reference to the coupling components 1716. Although a single IC package 1720 is shown in FIG. 12, multiple IC packages may be coupled to the interposer 1704; indeed, additional interposers may be coupled to the interposer 1704. The interposer 1704 may provide an intervening substrate used to bridge the circuit board 1702 and the IC package 1720. The IC package 1720 may be or include, for example, a die (the die 2002 of FIG. 10B), an IC device (e.g., the IC device 1600 of FIG. 11), or any other suitable component. In some embodiments, the IC package 1720 may include stacked optical, electronic, and/or hybrid layers, as described herein. Generally, the interposer 1704 may spread a connection to a wider pitch or reroute a connection to a different connection. For example, the interposer 1704 may couple the IC package 1720 (e.g., a die) to a ball grid array (BGA) of the coupling components 1716 for coupling to the circuit board 1702. In the embodiment illustrated in FIG. 12, the IC package 1720 and the circuit board 1702 are attached to opposing sides of the interposer 1704; in other embodiments, the IC package 1720 and the circuit board 1702 may be attached to a same side of the interposer 1704. In some embodiments, three or more components may be interconnected by way of the interposer 1704.

The interposer 1704 may be formed of an epoxy resin, a fiberglass-reinforced epoxy resin, a ceramic material, or a polymer material such as polyimide. In some implementations, the interposer 1704 may be formed of alternate rigid or flexible materials that may include the same materials described above for use in a semiconductor substrate, such as silicon, germanium, and other group III-V and group IV materials. The interposer 1704 may include metal interconnects 1708 and vias 1710, including but not limited to TSVs 1706. The interposer 1704 may further include embedded devices 1714, including both passive and active devices. Such devices may include, but are not limited to, capacitors, decoupling capacitors, resistors, inductors, fuses, diodes, transformers, sensors, electrostatic discharge (ESD) devices, and memory devices. More complex devices such as radio frequency (RF) devices, power amplifiers, power management devices, antennas, arrays, sensors, and microelectromechanical systems (MEMS) devices may also be formed on the interposer 1704. The package-on-interposer structure 1736 may take the form of any of the package-on-interposer structures known in the art.

The IC device assembly 1700 may include an IC package 1724 coupled to the first face 1740 of the circuit board 1702 by coupling components 1722. The coupling components 1722 may take the form of any of the embodiments discussed above with reference to the coupling components 1716, and the IC package 1724 may take the form of any of the embodiments discussed above with reference to the IC package 1720.

The IC device assembly 1700 illustrated in FIG. 12 includes a package-on-package structure 1734 coupled to the second face 1742 of the circuit board 1702 by coupling components 1728. The package-on-package structure 1734 may include an IC package 1726 and an IC package 1732 coupled together by coupling components 1730 such that the IC package 1726 is disposed between the circuit board 1702 and the IC package 1732. The coupling components 1728 and 1730 may take the form of any of the embodiments of the coupling components 1716 discussed above, and the IC packages 1726 and 1732 may take the form of any of the embodiments of the IC package 1720 discussed above. The package-on-package structure 1734 may be configured in accordance with any of the package-on-package structures known in the art.

FIG. 13 is a block diagram of an example computing device 1800 that may include one or more components including one or more IC structures with stacked optical, electronic, and/or hybrid layers in accordance with any of the embodiments disclosed herein. For example, any suitable ones of the components of the computing device 1800 may include a die (e.g., the die 2002 of FIG. 10B) having stacked optical, electronic, and/or hybrid layers as described herein. Any one or more of the components of the computing device 1800 may include, or be included in, an IC device 1600 (FIG. 11). Any one or more of the components of the computing device 1800 may include, or be included in, an IC device assembly 1700 (FIG. 12).

A number of components are illustrated in FIG. 13 as included in the computing device 1800, but any one or more of these components may be omitted or duplicated, as suitable for the application. In some embodiments, some or all of the components included in the computing device 1800 may be attached to one or more motherboards. In some embodiments, some or all of these components are fabricated onto a single system-on-a-chip (SoC) die.

Additionally, in various embodiments, the computing device 1800 may not include one or more of the components illustrated in FIG. 13, but the computing device 1800 may include interface circuitry for coupling to the one or more components. For example, the computing device 1800 may not include a display device 1806, but may include display device interface circuitry (e.g., a connector and driver circuitry) to which a display device 1806 may be coupled. In another set of examples, the computing device 1800 may not include an audio input device 1824 or an audio output device 1808 but may include audio input or output device interface circuitry (e.g., connectors and supporting circuitry) to which an audio input device 1824 or audio output device 1808 may be coupled.

The computing device 1800 may include a processing device 1802 (e.g., one or more processing devices). As used herein, the term "processing device" or "processor" may refer to any device or portion of a device that processes electronic data from registers and/or memory to transform that electronic data into other electronic data that may be stored in registers and/or memory. The processing device 1802 may include one or more digital signal processors (DSPs), application-specific ICs (ASICs), central processing units (CPUs), graphics processing units (GPUs), cryptoprocessors (specialized processors that execute cryptographic algorithms within hardware), server processors, or any other suitable processing devices. The computing device 1800 may include a memory 1804, which may itself include one or more memory devices such as volatile memory (e.g., dynamic random-access memory (DRAM)), nonvolatile memory (e.g., read-only memory (ROM)), flash memory, solid state memory, and/or a hard drive. In some embodiments, the memory 1804 may include memory that shares a die with the processing device 1802. This memory may be used as cache memory and may include embedded dynamic random-access memory (eDRAM) or spin transfer torque magnetic random-access memory (STT-MRAM).

In some embodiments, the computing device 1800 may include a communication chip 1812 (e.g., one or more communication chips). For example, the communication chip 1812 may be configured for managing wireless communications for the transfer of data to and from the computing device 1800. The term "wireless" and its derivatives may be used to describe circuits, devices, systems, methods, techniques, communications channels, etc., that may communicate data through the use of modulated electromagnetic radiation through a nonsolid medium. The term does not imply that the associated devices do not contain any wires, although in some embodiments they might not.

The communication chip 1812 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultramobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. The communication chip 1812 may operate in accordance with a Global System for Mobile Communication (GSM), General Packet Radio Service (GPRS), Universal Mobile Telecommunications System (UMTS), High-Speed Packet Access (HSPA), Evolved HSPA (E-HSPA), or LTE network. The communication chip 1812 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). The communication chip 1812 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. The communication chip 1812 may operate in accordance with other wireless protocols in other embodiments. The computing device 1800 may include an antenna 1822 to facilitate wireless communications and/or to receive other wireless communications (such as AM or FM radio transmissions).

In some embodiments, the communication chip 1812 may manage wired communications, such as electrical, optical, or any other suitable communication protocols (e.g., the Ethernet). As noted above, the communication chip 1812 may include multiple communication chips. For instance, a first communication chip 1812 may be dedicated to shorter-range wireless communications such as Wi-Fi or Bluetooth, and a second communication chip 1812 may be dedicated to longer-range wireless communications such as global positioning system (GPS), EDGE, GPRS, CDMA, WiMAX, LTE, EV-DO, or others. In some embodiments, a first communication chip 1812 may be dedicated to wireless communications, and a second communication chip 1812 may be dedicated to wired communications.

The computing device 1800 may include battery/power circuitry 1814. The battery/power circuitry 1814 may include one or more energy storage devices (e.g., batteries or capacitors) and/or circuitry for coupling components of the computing device 1800 to an energy source separate from the computing device 1800 (e.g., AC line power).

The computing device 1800 may include a display device 1806 (or corresponding interface circuitry, as discussed above). The display device 1806 may include any visual indicators, such as a heads-up display, a computer monitor, a projector, a touchscreen display, a liquid crystal display (LCD), a light-emitting diode display, or a flat panel display, for example.

The computing device 1800 may include an audio output device 1808 (or corresponding interface circuitry, as discussed above). The audio output device 1808 may include any device that generates an audible indicator, such as speakers, headsets, or earbuds, for example.

The computing device 1800 may include an audio input device 1824 (or corresponding interface circuitry, as discussed above). The audio input device 1824 may include any device that generates a signal representative of a sound, such as microphones, microphone arrays, or digital instruments (e.g., instruments having a musical instrument digital interface (MIDI) output).

The computing device 1800 may include a GPS device 1818 (or corresponding interface circuitry, as discussed above). The GPS device 1818 may be in communication with a satellite-based system and may receive a location of the computing device 1800, as known in the art.

The computing device 1800 may include an other output device 1810 (or corresponding interface circuitry, as discussed above). Examples of the other output device 1810 may include an audio codec, a video codec, a printer, a wired or wireless transmitter for providing information to other devices, or an additional storage device.

The computing device 1800 may include an other input device 1820 (or corresponding interface circuitry, as discussed above). Examples of the other input device 1820 may include an accelerometer, a gyroscope, a compass, an image capture device, a keyboard, a cursor control device such as a mouse, a stylus, a touchpad, a bar code reader, a Quick Response (QR) code reader, any sensor, or a radio frequency identification (RFID) reader.

The computing device 1800 may have any desired form factor, such as a hand-held or mobile computing device (e.g., a cell phone, a smart phone, a mobile internet device, a music player, a tablet computer, a laptop computer, a netbook computer, an ultrabook computer, a personal digital assistant (PDA), an ultramobile personal computer, etc.), a desktop computing device, a server or other networked computing component, a printer, a scanner, a monitor, a set-top box, an entertainment control unit, a vehicle control unit, a digital camera, a digital video recorder, or a wearable computing device. In some embodiments, the computing device 1800 may be any other electronic device that processes data.

The above description of illustrated implementations of the disclosure, including what is described in the Abstract, is not intended to be exhaustive or to limit the disclosure to the precise forms disclosed. While specific implementations of, and examples for, the disclosure are described herein for illustrative purposes, various equivalent modifications are possible, as those skilled in the relevant art will recognize. These modifications may be made to the disclosure in light of the above detailed description. The invention is limited by the scope of the appended claims.

## Claims

1. A hybrid integrated circuit (IC) assembly (100; 200; 300; 400; 700; 800) comprising:
a first IC structure (110) comprising a waveguide formed of a substantially monocrystalline material, the first IC structure having a front face;
a second IC structure (120) comprising at least one electronic circuit element and a second waveguide formed of a substantially monocrystalline material, the second IC structure having a back face; and
a bonding layer (130) between the front face of the first IC structure and the back face of the second IC structure, the bonding layer comprising a bonding material having a lower crystallinity than the waveguides in the first IC structure (110) and the second IC structure (120).

2. The hybrid IC assembly of claim 1, wherein the first IC structure further comprises at least one electronic circuit element.

3. The hybrid IC assembly of one of the previous claims, wherein the at least one electronic circuit element comprises a heating element located proximate to an optical element, the heating element to modulate a wavelength of light in the optical element.

4. The hybrid IC assembly of claim 3, wherein the optical element is in the second IC structure.

5. The hybrid IC assembly of claim 3 or 4, wherein the optical element is in the first IC structure.

6. The hybrid IC assembly of claim 5, wherein the optical element is formed on a front side of the first IC structure, and the heating element is on a back side of the second IC structure.

7. The hybrid IC assembly of one of the previous claims, wherein the waveguide couples a first portion of the IC assembly to a second portion of the IC assembly.

8. The hybrid IC assembly of claim 7, wherein the first portion of the IC assembly is the first IC structure, the second portion of the IC assembly is the second IC structure, and the waveguide comprises an optical via that couples the first IC structure and the second IC structure through the bonding layer.

9. The hybrid IC assembly of claim 7 or 8, wherein the first portion of the IC assembly is a first electronics portion of the first IC structure, and the second portion of the IC assembly is a second electronics portion of the first IC structure.

10. The hybrid IC assembly of any of the preceding claims, wherein the substantially monocrystalline material has a grain size of at least 5 nanometers.

11. The hybrid IC assembly of any of the preceding claims, wherein the bonding layer is a polycrystalline material.

12. The hybrid IC assembly of claim 11, wherein the bonding layer has a grain size between 1 and 20 nanometers.

13. The hybrid IC assembly of any of claims 1 through 10, wherein the bonding layer is an amorphous material.

14. The hybrid IC assembly of any of the preceding claims, wherein the second IC structure comprises a plurality of memory cells.

15. The hybrid IC assembly of any of the claims 1 to 14, wherein the second IC structure is a processing device.

## Patentansprüche

1. Hybride integrierte Schaltungsanordung (hybride IC-Anordnung) (100; 200; 300; 400; 700; 800), umfassend:
eine erste IC-Struktur (110), die einen Wellenleiter umfasst, der aus einem im Wesentlichen monokristallinen Material gebildet ist, wobei die erste IC-Struktur eine Vorderseite aufweist;
eine zweite IC-Struktur (120), die mindestens ein elektronisches Schaltungselement und einen zweiten Wellenleiter umfasst, der aus einem im Wesentlichen monokristallinen Material gebildet ist, wobei die zweite IC-Struktur eine Rückseite aufweist; und
eine Bondschicht (130) zwischen der Vorderseite der ersten IC-Struktur und der Rückseite der zweiten IC-Struktur, wobei die Bondschicht ein Bondmaterial mit einer niedrigeren Kristallinität als die Wellenleiter in der ersten IC-Struktur (110) und der zweiten IC-Struktur (120) umfasst.

2. Hybride IC-Anordnung nach Anspruch 1, wobei die erste IC-Struktur ferner mindestens ein elektronisches Schaltungselement umfasst.

3. Hybride IC-Anordnung nach einem der vorhergehenden Ansprüche, wobei das mindestens eine elektronische Schaltungselement ein Heizelement umfasst, das sich in der Nähe eines optischen Elements befindet, wobei das Heizelement geeignet ist, um eine Lichtwellenlänge in dem optischen Element zu modulieren.

4. Hybride IC-Anordnung nach Anspruch 3, wobei sich das optische Element in der zweiten IC-Struktur befindet.

5. Hybride IC-Anordnung nach Anspruch 3 oder 4, wobei sich das optische Element in der ersten IC-Struktur befindet.

6. Hybride IC-Anordnung nach Anspruch 5, wobei das optische Element an einer Vorderseite der ersten IC-Struktur gebildet ist und wobei sich das Heizelement an einer Rückseite der zweiten IC-Struktur befindet.

7. Hybride IC-Anordnung nach einem der vorhergehenden Ansprüche, wobei der Wellenleiter einen ersten Abschnitt der IC-Anordnung mit einem zweiten Abschnitt der IC-Anordnung koppelt.

8. Hybride IC-Anordnung nach Anspruch 7, wobei der erste Abschnitt der IC-Anordnung die erste IC-Struktur ist, wobei der zweite Abschnitt der IC-Anordnung die zweite IC-Struktur ist und wobei der Wellenleiter eine optische Durchkontaktierung umfasst, welche die erste IC-Struktur und die zweite IC-Struktur durch die Bondschicht miteinander koppelt.

9. Hybride IC-Anordnung nach Anspruch 7 oder 8, wobei sich der erste Abschnitt ein erster elektronischer Abschnitt der ersten IC-Struktur ist und wobei der zweite Abschnitt der IC-Anordnung ein zweiter elektronischer Abschnitt der ersten IC-Struktur ist.

10. Hybride IC-Anordnung nach einem der vorhergehenden Ansprüche, wobei das im Wesentlichen monokristalline Material eine Korngröße von mindestens 5 Nanometern aufweist.

11. Hybride IC-Anordnung nach einem der vorhergehenden Ansprüche, wobei die Bondschicht ein polykristallines Material ist.

12. Hybride IC-Anordnung nach Anspruch 11, wobei die Bondschicht eine Korngröße zwischen 1 und 20 Nanometern aufweist.

13. Hybride IC-Anordnung nach einem der Ansprüche 1 bis 10, wobei die Bondschicht ein amorphes Material ist.

14. Hybride IC-Anordnung nach einem der vorherigen Ansprüche, wobei die zweite IC-Struktur eine Vielzahl von Speicherzellen umfasst.

15. Hybride IC-Anordnung nach einem der Ansprüche 1 bis 14, wobei die zweite IC-Struktur eine Verarbeitungsvorrichtung ist.

## Revendications

1. Ensemble de circuit intégré (IC) hybride (100 ; 200 ; 300 ; 400 ; 700 ; 800) comprenant :
une première structure IC (110) comprenant un guide d'onde formé par un matériau sensiblement monocristallin, la première structure IC ayant une face avant ;
une seconde structure IC (120) comprenant au moins un élément de circuit électronique et un second guide d'ondes formé d'un matériau sensiblement monocristallin, la seconde structure IC ayant une face arrière ; et
une couche de liaison (130) entre la face avant de la première structure IC et la face arrière de la seconde structure IC, la couche de liaison comprenant un matériau de liaison présentant une cristallinité inférieure à celle des guides d'ondes de la première structure IC (110) et de la seconde structure IC (120).

2. Ensemble IC hybride selon la revendication 1, la première structure IC comprenant en outre au moins un élément de circuit électronique.

3. Ensemble IC hybride selon l'une des revendications précédentes, l'au moins un élément de circuit électronique comprenant un élément chauffant situé à proximité d'un élément optique, l'élément chauffant servant à moduler une longueur d'onde de lumière dans l'élément optique.

4. Ensemble IC hybride selon la revendication 3, l'élément optique se trouvant dans la seconde structure IC.

5. Ensemble IC hybride selon la revendication 3 ou 4, l'élément optique se trouvant dans la première structure IC.

6. Ensemble IC hybride selon la revendication 5, l'élément optique étant formé sur un côté avant de la première structure IC, et l'élément chauffant étant sur un côté arrière de la seconde structure IC.

7. Ensemble IC hybride selon l'une des revendications précédentes, le guide d'ondes couplant une première partie de l'ensemble IC à une seconde partie de l'ensemble IC.

8. Ensemble IC hybride selon la revendication 7, la première partie de l'ensemble IC étant la première structure IC, la seconde partie de l'ensemble IC étant la seconde structure IC, et le guide d'ondes comprenant un trou d'interconnexion optique qui couple la première structure IC et la seconde structure IC à travers la couche de liaison.

9. Ensemble IC hybride selon la revendication 7 ou 8, la première partie de l'ensemble IC étant une première partie électronique de la première structure IC, et la seconde partie de l'ensemble IC étant une seconde partie électronique de la première structure IC.

10. Ensemble IC hybride selon l'une quelconque des revendications précédentes, le matériau sensiblement monocristallin ayant une taille de grain d'au moins 5 nanomètres.

11. Ensemble IC hybride selon l'une quelconque des revendications précédentes, la couche de liaison étant un matériau polycristallin.

12. Ensemble IC hybride selon la revendication 11, la couche de liaison ayant une taille de grain comprise entre 1 et 20 nanomètres.

13. Ensemble IC hybride selon l'une quelconque des revendications 1 à 10, la couche de liaison étant un matériau amorphe.

14. Ensemble IC hybride selon l'une quelconque des revendications précédentes, la seconde structure IC comprenant une pluralité de cellules de mémoire.

15. Ensemble IC hybride selon l'une quelconque des revendications 1 à 14, la seconde structure IC étant un dispositif de traitement.
